# EUROPEAN PATENT APPLICATION

(11) **EP 4 654 259 A1**
(43) Date of publication of application: **26.11.2025**
(21) Application number: 24763705.1
(22) Date of filing: 20.02.2024
(51) Int. Cl.: H01L 23/36, C04B 41/88, C22C 1/10, C23C 18/16, H01L 23/14

(54) **CERAMIC PLATE, PACKAGE, CERAMIC PLATE MANUFACTURING METHOD, MODULE, AND ELECTRIC/ELECTRONIC COMPONENT**

(30) Priority: 27.02.2023 JP 2023028700
(71) Applicant: Denka Company Limited, Tokyo 103-8338 (JP)
(72) Inventor: GOTO, Daisuke, Tokyo 103-8338 (JP); ONO, Hiroshi, Tokyo 103-8338 (JP)
(74) Representative: Hoffmann Eitle
(86) International application number: PCT/JP2024/005969
(87) International publication number: WO 2024/181224

(57) **Abstract**

There is provided a ceramic plate including a plating film on at least a part of a surface of a plate-like ceramic member. When the ceramic plate is heated from 25°C to 400°C at a temperature rising rate of 5 °C/min according to a temperature-programmed desorption gas analysis method, a release amount A₂₅₀ of hydrogen per unit mass of the ceramic plate at 250°C is 5.0 × 10⁻¹⁰ A/g or less in terms of a mass spectral intensity based on an ion current value.

## Description

### TECHNICAL FIELD

The present invention relates to a ceramic plate, a package, a manufacturing method for a ceramic plate, a module, and an electric or electronic product. More specifically, the present invention relates to a ceramic plate including a plating film, a package in which the ceramic plate is sealed with a packaging container, a manufacturing method for the ceramic plate, a module using the ceramic plate, and an electric or electronic product including the module.

### BACKGROUND ART

In electric or electronic products, a ceramic plate, specifically, a ceramic plate including a composite body of a metal and a ceramic such as silicon carbide is sometimes used as a heat dissipation member for dissipating heat generated from an electronic component.

The heat dissipation member typically includes a plating film on at least a part of a surface of the plate-like ceramic member.

Solder is generally used for connection between an electronic component that dissipates heat and a heat dissipation member. Therefore, in a case where the heat dissipation member includes the plating film, wettability of the solder is increased, and the electronic component and the heat dissipation member are easily connected to each other.

For example, Patent Document 1 and Patent Document 2 describe a plate-shaped heat dissipation member including a metal-silicon carbide composite containing aluminum or magnesium. These documents describe that a plate-shaped heat dissipation member is manufactured by subjecting a surface of a metal-silicon carbide-based composite material containing aluminum or magnesium to Ni plating. In addition, these documents describe that the heat dissipation member and the power element are connected by soldering.

### RELATED DOCUMENT

### PATENT DOCUMENT

Patent Document 1: Pamphlet of International Publication No. WO 2020/158774
Patent Document 2: Pamphlet of International Publication No. WO 2020/158775

### SUMMARY OF THE INVENTION

### TECHNICAL PROBLEM

As described above, the ceramic plate (heat dissipation member) including a plating film on at least a part of the surface of the plate-like ceramic member and the electronic component may be connected by soldering.

In the course of studying the improvement of the ceramic plate (heat dissipation member), the present inventors have found that the ceramic plate and the electronic component may not be appropriately connected to each other by soldering.

The present invention was made in consideration of these circumstances. One of the objects of the present invention is to provide a ceramic plate that can be appropriately connected to an electronic component by soldering.

### SOLUTION TO PROBLEM

The present inventors completed the inventions provided below and solved the above-described problems.

1. A ceramic plate including:
   a plating film on at least a part of a surface of a plate-like ceramic member,
   in which when the ceramic plate is heated from 25°C to 400°C at a temperature rising rate of 5 °C/min according to a temperature-programmed desorption gas analysis method, a release amount A₂₅₀ of hydrogen per unit mass of the ceramic plate at 250°C is 5.0 × 10⁻¹⁰ A/g or less in terms of a mass spectral intensity based on an ion current value.
2. The ceramic plate according to 1.,
   in which when a release amount of hydrogen per unit mass of the ceramic plate at 300°C in a measurement by the temperature-programmed desorption gas analysis method is defined as A₃₀₀, a value of A₂₅₀/A₃₀₀ is 0.3 or less.
3. The ceramic plate according to 1. or 2.,
   in which in a measurement by the temperature-programmed desorption gas analysis method, a release amount A₃₀₀ of hydrogen per unit mass of the ceramic plate at 300°C is 5.0 × 10⁻⁹ A/g or less in terms of a mass spectral intensity based on an ion current value.
4. The ceramic plate according to any one of 1. to 3.,
   in which the plating film is an electroless plating film.
5. The ceramic plate according to any one of 1. to 4.,
   in which the plating film contains at least any element selected from the group consisting of nickel and copper.
6. The ceramic plate according to any one of 1. to 5.,
   in which a material of the plate-like ceramic member is a metal-silicon carbide composite.
7. A ceramic plate according to 6.,
   in which a metal in the metal-silicon carbide composite is at least any one selected from the group consisting of aluminum and magnesium.
8. The ceramic plate according to any one of 1. to 7.,
   in which a hydrogen cumulative release amount per unit mass of the ceramic plate in a measurement by the temperature-programmed desorption gas analysis method is 2 × 10⁻² mL/g or less.
9. A package in which the ceramic plate according to any one of 1. to 8. is sealed with a packaging container.
10. A manufacturing method for the ceramic plate according to any one of 1. to 8., the method including:
   a heating step of heating a material that includes the plating film on at least a part of the surface of the plate-like ceramic member at 190°C or higher.
11. A manufacturing method for the ceramic plate according to 10.,
   wherein in the heating step, the heating is performed for 30 minutes or more.
12. A module in which the ceramic plate according to any one of 1. to 8. and an electronic component are connected to each other by solder.
13. An electric or electronic product including the module according to 12.

### ADVANTAGEOUS EFFECTS OF INVENTION

According to the present invention, there is provided a ceramic plate that can be appropriately connected to an electronic component by soldering.

### BRIEF DESCRIPTION OF THE DRAWINGS

[FIG. 1] A view for explaining a ceramic plate.
[FIG. 2] A view for explaining a ceramic plate.
[FIG. 3] A view for explaining a manufacturing method for a ceramic plate.

### DESCRIPTION OF EMBODIMENTS

A detailed explanation will be given below of an embodiment of the present invention with reference to the drawings.

In the drawings, the same constituent elements are denoted by the same reference signs, and detailed description thereof will not be repeated.

To avoid complexity, in a case where there are a plurality of identical constituent components in the same drawing, only one thereof may be labeled with a reference numeral, or not all thereof may be provided with a reference numeral.

The drawings are for illustrative purposes only. The shapes, dimensional ratios, and the like of each of the members in the drawings do not necessarily correspond to the actual products.

In the present specification, the notation "X to Y" in the explanation of the range of values means equal to or more than X and equal to or less than Y, unless otherwise specified. For example, "1% to 5% by mass" means "1% by mass or more and 5% by mass or less".

The term "ceramics" in the present specification is used to include not only ceramics in a narrow sense but also a composite material consisting of a metal and ceramics, unless otherwise specified. In particular, as will be described later, the material of the plate-like ceramic member can be a composite of a metal and a ceramic such as silicon carbide.

### <Ceramic Plate 1>

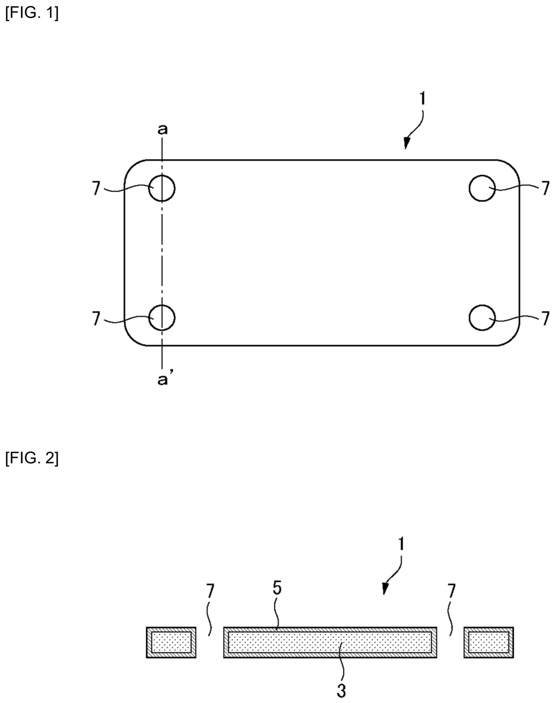

FIGS. 1 and 2 are diagrams schematically showing a ceramic plate (ceramic plate 1) of the present embodiment. FIG. 1 shows a shape of the ceramic plate 1 in a case where the ceramic plate 1 is viewed from above with one main surface as an upper surface. FIG. 2 is a cross-sectional view taken along line a-a' of FIG. 1.

The ceramic plate 1 includes a plating film 5 on at least a part (may be all) of a surface of the plate-like ceramic member 3.

The ceramic plate 1 may have one or more holes 7.

The shape of the ceramic plate 1 in a plan view is generally substantially rectangular. One or all of the four corners of the ceramic plate 1 which is substantially rectangular may have a shape that is not a right angle shape and is slightly rounded. Of course, the four corners may have a rectangular shape.

The ceramic plate 1 may be a plate shape having substantially no distortion and a flat surface, or may be a plate shape having a curve. In a case where the ceramic plate 1 is used while being fixed to other components with a fixing member such as a screw, the bonding surface with the other components is curved in a convex shape, so that the bonding surface is "appropriately flat" in a case where the ceramic plate 1 is fixed with the fixing member, and thus the bonding property (adhesiveness) with the other components can be improved.

The length of the ceramic plate 1 shown in FIG. 1 in the vertical and horizontal directions is usually about 40 mm × 90 mm to 140 mm × 250 mm. In addition, the thickness of the ceramic plate 1 shown in FIG. 2 is, for example, 2 to 6 mm and preferably 3 to 5 mm. In a case where the thickness of the ceramic plate 1 is not uniform, it is preferable that at least the thickness of the ceramic plate 1 in the center of gravity portion is in the above-described range. Alternatively, in a case where the thickness of the ceramic plate 1 is not uniform, it is preferable that the thickness of each portion other than the hole is within the above range.

In a case where the ceramic plate 1 is heated from 25°C to 400°C at a temperature rising rate of 5 °C/min by a temperature-programmed desorption gas analysis method, a release amount A₂₅₀ of hydrogen per unit mass of the ceramic plate 1 at 250°C is 5.0 × 10⁻¹⁰ A/g or less in terms of a mass spectral intensity according to an ion current value.

Here, the amount A₂₅₀ of hydrogen released is a release amount A of hydrogen at a temperature T of 250°C in a hydrogen gas release curve obtained by continuously measuring the amount of hydrogen released by the heating according to a temperature-programmed desorption gas analysis method and plotting the amount of hydrogen released (mass spectral intensity based on ion current value) A per unit mass of the ceramic plate 1 on a vertical axis and the temperature T on a horizontal axis.

The ceramic plate 1 in which A₂₅₀ is 5.0 × 10⁻¹⁰ A/g or less in terms of the mass spectral intensity based on the ion current value can be manufactured by using an appropriate raw material and going through an appropriate manufacturing process. It is preferable that the manufacturing process includes a step of heating a material including a plating film on at least a part of a surface of the ceramic plate at 190°C or higher.

Details of raw materials and manufacturing processes will be described later.

The reason why the ceramic plate of the present embodiment can be appropriately connected to an electronic component by soldering will be described as follows based on the background of the study by the present inventors. It should be noted that the following description includes presumptions, and the present invention is not limited to the following description.

The present inventors have examined the causes of the fact that the ceramic plate and the electronic component cannot be appropriately connected to each other by soldering from various viewpoints.

Through the examination, the present inventors have newly found that voids may be generated in the solder that bonds the ceramic plate and the electronic component, and these voids may deteriorate the bondability between the ceramic plate and the electronic component.

As a result of further studies, the present inventors have newly found that the voids in the solder are caused by hydrogen released from the plating film. Specifically, in a case where a ceramic plate including a plating film and an electronic component are joined by solder by reflow, hydrogen gas may be released from the plating film due to heating of the reflow. The inventors of the present invention newly found that the voids are included in the solidified solder as the hydrogen gas is incorporated into the molten solder and the solder is solidified as it is.

Based on such a new finding, the present inventors set the release amount of hydrogen in a case where the ceramic plate is heated as a design index for improving the joinability between the ceramic plate and the electronic component by solder. Then, a ceramic plate having a small index was newly designed. As a result, a ceramic plate 1 in which A₂₅₀ was 5.0 × 10⁻¹⁰ A/g or less in terms of the mass spectral intensity based on the ion current value was completed.

The completed ceramic plate 1 is capable of appropriately connecting electronic components by soldering.

The description of the ceramic plate 1 will be continued.

### (Plate-like Ceramic Member 3: In Particular Material and Manufacturing Method)

The material of the plate-like ceramic member 3 is preferably a metal-silicon carbide composite. In addition, the metal in the metal-silicon carbide composite preferably includes at least any one selected from the group consisting of aluminum and magnesium.

A method that is preferably used for manufacturing the plate-like ceramic member 3 is a high-pressure forging method in which a porous body is impregnated with a metal under high pressure. More specifically, squeeze casting or die casting can be adopted. The high-pressure forging method is a method in which a porous body (preform) of silicon carbide is loaded into a container that can withstand high pressure, and a molten metal is impregnated into the porous body at a high pressure to obtain a composite.

From the reason that a large amount of the plate-like ceramic member 3 can be stably manufactured, a molten metal forging method is particularly preferable as a manufacturing method for the plate-like ceramic member 3. Hereinafter, the manufacturing method using squeeze casting will be described.

### · Manufacturing of Porous Silicon Carbide Body (SiC Preform)

In the manufacturing of the plate-like ceramic member 3, first, a flat plate-like porous silicon carbide body (SiC preform) is formed. The manufacturing method is not particularly limited, and a well-known method can be manufactured. For example, the porous silicon carbide body can be manufactured by adding silica, alumina, or the like as a binder to silicon carbide (SiC) powder as a raw material, mixing the components, molding and calcinating the mixture at equal to or higher than 800°C. For the sake of completeness, here, the porous silicon carbide body may not be composed of only silicon carbide as a chemical component, and for example, 50% by volume or more of the entire porous silicon carbide body may be composed of silicon carbide.

The molding method is not particularly limited, and press molding, extrusion molding, casting molding, or the like can be adopted. In addition, a binder for maintaining the shape can be used as necessary.

Important characteristics of the plate-like ceramic member 3 in which the metal is impregnated in the porous silicon carbide body are thermal conductivity and a coefficient of thermal expansion. It is preferable that the SiC content in the porous silicon carbide body is high because the thermal conductivity is high and the thermal expansion coefficient is low. It is noted that, when the content is excessively high, the porous silicon carbide body is not sufficiently impregnated with a metal.

In practice, suitably, equal to or higher than 40 mass% of coarse SiC particles having an average particle size of preferably equal to or more than 40 µm are contained, and the relative density of the SiC preform is preferably in a range of equal to or higher than 55% and equal to or lower than 75%. The bending strength of the porous silicon carbide body (SiC preform) is preferably 3 MPa or higher in order to prevent fracturing during handling or impregnation. The average particle size can be measured by calculating the average value of particle sizes of 1000 particles using a scanning electron microscope (for example, "JSM-T200 model", manufactured by JEOL Ltd.) and an image analyzer (for example, manufactured by Nippon Avionics Co., Ltd.). The relative density can be measured by an Archimedes method or the like.

It is preferable that the particle size of the SiC powder as a raw material of the porous silicon carbide body (SiC preform) is adjusted by appropriately using coarse powder and fine powder in combination. As a result, the strength of the porous silicon carbide body (SiC preform) and the thermal conductivity of the heat dissipation member that is finally obtained can be improved at a high level.

Specifically, mixed powder obtained by mixing (i) SiC coarse powder having an average particle size of equal to or more than 40 µm and equal to or less than 150 µm and (ii) SiC fine powder having an average particle size of equal to or more than 5 µm and equal to or less than 15 µm is suitable. Here, regarding a ratio between the amount of (i) and the amount of (ii) in the mixed powder, the amount of (i) is equal to or higher than 40 mass% and equal to or lower than 80 mass%, and the amount of (ii) is preferably equal to or higher than 20 mass% and equal to or lower than 60 mass%.

The porous silicon carbide body (SiC preform) is obtained by, for example, degreasing and calcinating a compact of a mixture obtained by adding the binder to the SiC powder. When the calcination temperature is 800°C or higher, a porous silicon carbide body (SiC preform) having a bending strength of 3 MPa or higher is likely to be obtained irrespective of the atmosphere during the calcination.

It is noted that, when the calcination is performed at a temperature exceeding 1100°C in an oxidizing atmosphere, the oxidation of SiC is promoted, and the thermal conductivity of the metal-silicon carbide composite may decrease. Accordingly, it is preferable that the calcination is performed at a temperature of equal to or lower than 1100°C in the oxidizing atmosphere.

The calcination time may be appropriately determined depending on conditions such as the size of the porous silicon carbide body (SiC preform), the amount of raw materials charged into a calcination furnace, or the calcination atmosphere.

When the porous silicon carbide body (SiC preform) is molded in a predetermined shape, a change in shape (change in the amount of curve) caused by drying can be prevented by performing drying one by one or by performing drying using a spacer such as carbon having the same shape as the preform shape between SiC preforms. In addition, by performing the same treatment as that during drying for the calcination, a shape change caused by a change in internal structure can be prevented.

### · Impregnation with Metal

The plate-like ceramic member 3 can be obtained by impregnating the porous silicon carbide body (SiC preform) obtained as described above with a metal by a high-pressure forging method or the like. The metal here preferably includes aluminum or magnesium. In addition, the metal here may be an alloy.

As a method of obtaining the plate-like ceramic member 3 by impregnating the porous silicon carbide body (SiC preform) with a metal, for example, the following method is available.

First, the porous silicon carbide body (SiC preform) is set into a mold. Then, the molten metal (preferably, a metal containing aluminum or magnesium) is charged into the mold. Then, the molten metal is pressed. As a result, the metal is impregnated in the voids of the porous silicon carbide body (SiC preform). After cooling, a plate-like ceramic member 3 is obtained.

In a case where the porous silicon carbide body (SiC preform) is set in the mold, it is preferable to perform preheating. The preheating temperature is, for example, 500°C to 650°C. In order to prevent a temperature decrease, it is preferable that the molten metal is charged as rapidly as possible after setting the porous silicon carbide body (SiC preform) to the mold.

Incidentally, in a case where a plate-like ceramic member 3 is obtained by impregnating a porous silicon carbide body (SiC preform) with a metal, a surface metal layer may be provided on a surface (main surface or the like) of the plate-like ceramic member 3. As a result, it is possible to obtain the plate-like ceramic member 3 having the surface metal layer (specifically, the surface metal layer containing aluminum or magnesium) on the surfaces of the two main surfaces and the like. Of course, the surface metal layer may not be provided.

For example, a mold having a slightly larger dimension than the dimension of the SiC preform is prepared as the mold for the impregnation, the SiC preform is disposed in the mold, and the molten metal is poured thereinto. As a result, the surface metal layer can be provided.

In another example, the surface metal layer can be provided by impregnating the SiC preform with the metal in a state where one or more kinds among fibers, spherical particles, and crushed particles formed of alumina or silica are disposed to be in direct contact with the surface of the SiC preform. In this case, the content of the material consisting of one or more of fibers, spherical particles, and crushed particles, which are formed of alumina or silica, in the surface metal layer is preferably 1% by volume or more and 10% by mass or less, and more preferably 3% by volume or more and 8% by mass or less with respect to the surface metal layer.

In still another example, the surface metal layer can be provided using a method of disposing a thin sheet or a thin film of the metal on the surface of the SiC preform and impregnating the SiC preform with the metal, a method of providing a groove or the like on the surface of the preform, or the like.

The press pressure of the molten metal is not particularly limited as long as the metal can be sufficiently impregnated, and is, for example, equal to or higher than 30 MPa.

It is preferable that the melting point of the metal (preferably, the alloy containing aluminum or magnesium) to be impregnated is appropriately low so as to sufficiently permeate into the voids of the preform.

From this viewpoint, for example, an aluminum alloy containing 7 mass% or higher and 25 mass% or lower of silicon is preferable. Further, it is preferable to contain equal to or higher than 0.2 mass% and equal to or lower than 5 mass% of magnesium from the viewpoint that the binding between the silicon carbide powder and the metal portion becomes more strong. Metal components in the aluminum alloy other than aluminum, silicon, and magnesium are not particularly limited within a range where characteristics do not change extremely. For example, copper may be included.

As the aluminum alloy, for example, AC4C, AC4CH, or ADC12 that is an alloy for forging can be preferably used.

Incidentally, the plate-like ceramic member 3 may be subjected to an annealing treatment for the purpose of removing distortion generated during the impregnation. The annealing treatment can be performed, for example, under conditions of a temperature of about 400°C to 550°C for 10 minutes or more.

The plate-like ceramic member 3 obtained as described above may be substantially flat or may have uncontrolled curvature. However, for example, in the heating press step described below, the uncontrolled curvature can be flattened or a desired curvature can be imparted.

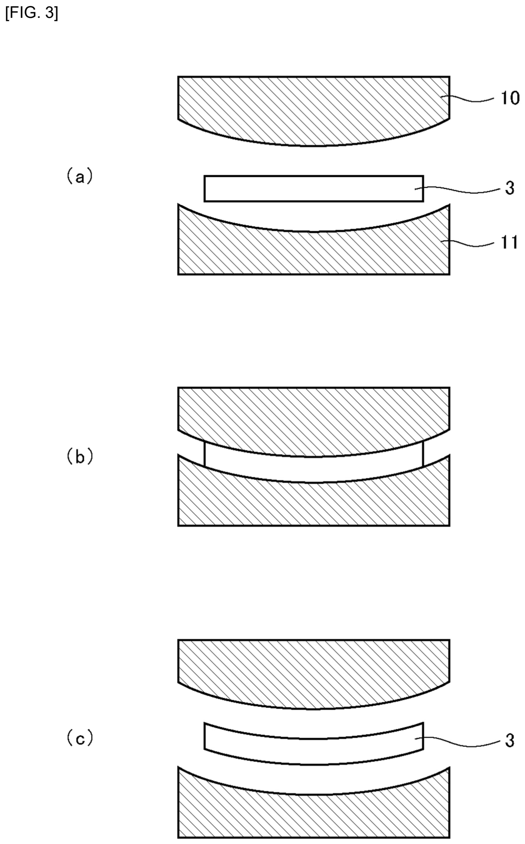

Hereinafter, a case where the desired curvature is imparted to the plate-like ceramic member 3 by the heating press step will be described. In a case where it is desired to flatten the plate-like ceramic member 3 having uncontrolled curvature, the press convex mold 10 and the press concave mold 11 in FIG. 3 may be replaced with a flat mold.

### · Heating Press Step

In the heating and pressing step, for example, as shown in FIGS. 3(a), 3(b), and 3(c), the plate-like ceramic member 3 is interposed between a pressing convex mold 10 and a pressing concave mold 11 and is heated and pressed, that is, pressed while being heated. As a result, it is possible to obtain the plate-like ceramic member 3 to which the desired curvature is applied.

The press convex mold 10 and the press concave mold 11 are subjected to shape processing so that the plate-like ceramic member 3 is given a predetermined curvature.

Typically, the form of a convex portion of the press convex mold 10 and the form of a concave portion of the press concave mold 11 are substantially the same. That is, typically, in a case where the pressing convex mold 10 and the pressing concave mold 11 are overlapped without interposing the plate-like ceramic member 3, a gap is hardly or not formed between the pressing convex mold 10 and the pressing concave mold 11.

Materials of the press convex mold 10 and the press concave mold 11 are not particularly limited and may be any one as long as they are not substantially deformed under temperature and pressure conditions described below. Specifically, a ceramic such as carbon or boron nitride or a metal material such as cemented carbide or stainless steel is preferably used.

The heating temperature during the heating press is not particularly limited as long as the plate-like ceramic member 3 to which appropriate bending is applied (or which is appropriately flattened) is obtained. However, from the viewpoint of productivity and reducing the pressure, the heating temperature is preferably as high as possible within a range in which the metal contained in the plate-like ceramic member 3 does not melt. In consideration of the melting point of aluminum, magnesium, or the like, the heating temperature is preferably 450°C to 550°C.

As long as the plate-like ceramic member 3 to which appropriate bending is applied (or which is appropriately flattened) is obtained, the pressure during the heating and pressing is not particularly limited, and the pressure may be appropriately adjusted depending on the thickness of the plate-like ceramic member 3, the heating temperature, and the like. However, from the viewpoint of productivity, reliably imparting a curve (or reliably flattening), and the like, the pressure is preferably 10 kPa or more and more preferably 30 to 250 kPa.

The time of the heating press is not particularly limited as long as the plate-like ceramic member 3 to which appropriate bending is applied (or which is appropriately flattened) is obtained. However, from the viewpoint of reliably imparting the curvature (or reliably flattening the curvature), for example, the time during which the temperature of the plate-like ceramic member 3 itself is 450°C or higher is preferably 30 seconds or longer and more preferably 30 to 300 seconds.

In order to obtain (or flatten) a desired curvature, the heating and pressing step may be performed a plurality of times. For example, after performing the first heating press step using the first press convex mold 10 and the first press concave mold 11, the second heating press step may be performed using the second press convex mold 10 and the second press concave mold 11 having a curved shape different from that of the first press convex mold 10 and the first press concave mold 11.

After the heating press, the plate-like ceramic member 3 is cooled. Cooling may be, for example, rapid cooling or air cooling. Since the shape of the curvature or the flatness may change depending on the cooling method, it is preferable to appropriately set the cooling conditions in order to obtain a desired curvature or flat surface.

That is, in order to obtain the plate-like ceramic member 3 to which appropriate curvature is applied (or which is appropriately flattened), it is preferable to appropriately adjust and optimize the temperature and time of the heating press, the specific method of cooling after the heating press, and the like in addition to using the press convex mold 10 and the press concave mold 11 having an appropriate shape.

At least a part of the plate-like ceramic member 3 may be subjected to mechanical processing. The machining includes cutting, grinding, polishing, and the like.

For example, it is conceivable to finely adjust the curved shape of the plate-like ceramic member 3 by mechanical processing. In addition, for example, it is also considered that the surface roughness of the plate-like ceramic member 3 is appropriately adjusted by polishing the surface of the plate-like ceramic member 3, and the connectivity and the bondability with other members are further enhanced.

### (Plating Film 5)

The plating film 5 is usually present on the outermost surface of the ceramic plate 1. The plating film 5 contributes to improvement of the wettability of solder in a case where the electronic component and the ceramic plate 1 are connected by soldering, and also contributes to blocking the plate-like ceramic member 3 from the outside air to suppress the alteration of the plate-like ceramic member 3.

The plating film 5 may be an electrolytic plating film or an electroless plating film. From the viewpoint of reducing the release amount of hydrogen and suppressing solder voids, it is preferable that a part or the whole of the plating film 5 is an electroless plating film.

A material (a plating liquid or the like) for providing the plating film 5 and a procedure for providing the plating film 5 can appropriately refer to known technologies.

The plating film 5 preferably contains at least any element selected from the group consisting of nickel and copper. From the viewpoint of ease of plating treatment, availability of a plating liquid, and the like, the plating film 5 more preferably contains nickel.

Examples of the particularly preferred plating film 5 include a Ni-P plating film and a Ni-B plating film.

The plating film 5 may be a single layer or may be a laminate of two or more layers of plating films. For example, first, the Ni-P plating film may be formed on the surface of the plate-like ceramic member 3, and then the Ni-B plating film may be formed.

By laminating the Ni-P plating film capable of reducing the internal stress and the Ni-B plating film having good solderability on the surface of the plate-like ceramic member 3, a practically preferable ceramic plate 1 can be obtained.

The thickness of the plating film 5 is usually 4 to 15 µm and preferably 6 to 12 µm. In a case where the plating film 5 is appropriately thick, appropriate soldering is more easily performed. On the other hand, in a case where the plating film 5 is not too thick, the ratio of the plate-like ceramic members 3 in the ceramic plate 1 may be increased, and the heat dissipation properties in a case where the ceramic plate 1 is used as a heat dissipation member may be further improved.

As another expression, the ratio of the plating film 5 in the ceramic plate 1 based on the mass is usually 0.2% to 2.0% and preferably 0.5% to 1.5%.

### (Hole 7)

The hole 7 is usually a through-hole and is used for fixing the ceramic plate 1 to another member with a bolt. Preferably, holes 7 are formed in at least four corners of the ceramic plate 1.

The hole 7 is preferably provided by subjecting the plate-like ceramic member 3 to machining before the plating film 5 is provided. In the ceramic plate 1 shown in FIG. 2, the hole 7 is provided by machining the plate-like ceramic member 3 before the plating film 5 is provided, and then the plating film 5 is provided.

The diameter of the hole 7 in a case where the ceramic plate 1 is viewed from above is, for example, 3 to 10 mm and preferably 5 to 9 mm.

### (Non-Through Hole)

The ceramic plate 1 may have non-through holes such as a recess or a cup hole in addition to the hole 7 which is a through-hole. The non-through hole is used, for example, for positioning an electronic component or preform solder connected to the surface of the ceramic plate 1.

The non-through hole is preferably provided by subjecting the plate-like ceramic member 3 to machining before the plating film 5 is provided.

### (Additional Description of Release Amount of Hydrogen)

A₂₅₀ may be 5.0 × 10⁻¹⁰ A/g or less in terms of the mass spectral intensity based on the ion current value. A₂₅₀ is preferably 3.0 × 10⁻¹⁰ A/g or less. As A₂₅₀ is smaller, voids that can be generated in the solder are likely to be reduced, and thus the ceramic plate and the electronic component are likely to be appropriately connected to each other.

The lower limit of A₂₅₀ is preferably smaller, and may be 0. However, in practice, the lower limit value of A₂₅₀ is, for example, 1.0 × 10⁻¹² A/g or more and preferably 1.0 × 10-¹¹ A/g or more in terms of the mass spectral intensity based on the ion current value.

That is, A₂₅₀ is preferably 1.0 × 10⁻¹² to 5.0 × 10⁻¹⁰ A/g and more preferably 1.0 × 10-¹¹ to 5.0 × 10⁻¹⁰ A/g in terms of the mass spectral intensity based on the ion current value.

As an index different from A₂₅₀, a release amount A₃₀₀ of hydrogen in the ceramic plate 1 per unit mass at 300°C in the measurement by the temperature-programmed desorption gas analysis method may be considered. It is considered that, since A₃₀₀ is small, voids are suppressed from being generated in the solder even in a case where the reflow temperature is high or the reflow time is long. Then, it is considered that the ceramic plate and the electronic component can be more appropriately connected to each other.

Specifically, A₃₀₀ is preferably 5.0 × 10⁻⁹A/g or less and more preferably 1.0 × 10⁻⁹A/g or less in terms of the mass spectral intensity based on the ion current value. The lower limit of A₃₀₀ may be smaller, and may be 0. However, in practice, the lower limit value of A₃₀₀ is, for example, 1.0 × 10⁻¹² A/g, preferably 1.0 × 10⁻¹¹ A/g, and more preferably 1.0 × 10⁻¹⁰ A/g, in terms of the mass spectral intensity based on the ion current value. That is, A₃₀₀ is usually 1.0 × 10⁻¹² to 5.0 × 10⁻⁹ A/g, preferably 1.0 × 10⁻¹¹ to 5.0 × 10⁻⁹ A/g, and more preferably 1.0 × 10⁻¹⁰ to 1.0 × 10⁻⁹ A/g.

As still another index, it is also preferable to design the ceramic plate 1 such that the value of A₂₅₀/A₃₀₀ is 0.3 or less.

The fact that A₂₅₀/A₃₀₀ is 0.3 or less means that the amount of hydrogen released from the ceramic plate 1 is sufficiently small (1/3 or less) in heating at 250°C as compared with heating at 300°C. The melting temperature of the normal solder is lower than 300°C, and the heating temperature in a normal soldering process such as reflow is also often lower than 300°C. It can be said that A₂₅₀/A₃₀₀ being 0.3 or less indicates that the amount of hydrogen released from the ceramic plate 1 at the heating temperature in the normal soldering step is sufficiently small.

In other words, it is considered that even in a case where A₃₀₀ has a relatively large value, voids are suppressed from occurring in the solder in the normal soldering process in a case where A₂₅₀ has a sufficiently small value as compared with A₃₀₀.

From a different viewpoint from A₂₅₀ and A₃₀₀, the hydrogen cumulative release amount per unit mass of the ceramic plate 1 (the area of a portion sandwiched between the hydrogen gas release curve and the horizontal axis in a region from 25°C to 400°C) in a case of heating from 25°C to 400°C at a temperature rising rate of 5°C/min can be considered by a temperature-programmed desorption gas analysis method. In a case where this value is small, there is a tendency that the ceramic plate and the electronic component can be more appropriately connected to each other by soldering.

Specifically, this value is a mass spectral intensity based on an ion current value, and is preferably 2 × 10⁻² mL/g or less, more preferably 1.5 × 10⁻² mL/g or less, and still more preferably 1.0 × 10⁻² mL/g or less. The smaller the value, the better, but in practice, the lower limit of this value is, for example, 0.1 × 10⁻² mL/g, specifically 0.5 × 10⁻² mL/g.

### <Manufacturing Method for Ceramic Plate 1>

The ceramic plate 1 can be preferably manufactured by the following steps (1) to (3).

(1) A plate-like ceramic member 3 is manufactured.
   This step is described in the section of <Ceramic Plate 1> (Plate-Like Ceramic Member 3: In Particular Material and Manufacturing Method) described above. Therefore, the detailed description thereof will not be repeated.
(2) The plating film 5 is formed on at least a part (may be the entire surface) of the surface of the plate-like ceramic member 3 by subjecting the plate-like ceramic member 3 to a plating treatment. That is, a material including the plating film 5 on at least a part of the surface of the plate-like ceramic member 3 is produced.
   Regarding this step, the section of <Ceramic Plate 1> (Plating Film 5) described that the plating film 5 may be an electrolytic plating film or an electroless plating film. Therefore, the detailed description thereof will not be repeated.
(3) The material including the plating film 5 on at least a part of the surface of the plate-like ceramic member 3 in the above (2) is heated at 190°C or higher. It is considered that, by this heating, hydrogen is released from the ceramic plate 1 in advance before the connection between the ceramic plate 1 and the electronic component by soldering, and the release of hydrogen from the ceramic plate 1 during soldering is suppressed. That is, by performing the step (3), it is possible to manufacture a ceramic plate having a small amount of A₂₅₀ of hydrogen released.

The heating can be performed, for example, by putting the material obtained in the section (2) into a furnace of a forced air circulation type. Of course, the device that can be used for heating is not limited to the furnace of the forced air circulation type.

The heating atmosphere may be an inert atmosphere. For example, by using a N₂ atmosphere or an Ar atmosphere, oxidation of the surface of the plating film 5 can be suppressed. Of course, the heating may be carried out in the atmosphere instead of the inert atmosphere. It is considered that the hydrogen is sufficiently released from the ceramic plate 1 even in a case where the heating is carried out in the atmosphere.

From the viewpoint of sufficiently releasing hydrogen from the ceramic plate 1, it is preferable that the heating temperature is high. However, in a case where the heating temperature is too high, there is a high possibility that the ceramic plate 1 is altered or damaged, or that the ceramic plate 1 is unintentionally warped. In consideration of the above as a whole, the heating temperature is preferably 190°C to 300°C and more preferably 190°C to 270°C.

From the viewpoint of sufficiently releasing hydrogen from the ceramic plate 1, the heating time is preferably 30 minutes or more. In consideration of the manufacturing efficiency, the heating time is preferably 30 minutes to 3 hours, more preferably 40 minutes to 2 hours, and particularly preferably 45 minutes to 2 hours.

### <Package>

In order to prevent deterioration or alteration due to contact with the outside air, it is preferable that the ceramic plate 1 is sealed with a packaging container before use to limit contact with the outside air.

As the packaging container, a bag formed of an aluminum laminate film or a resin film is preferable.

In a case where the ceramic plate 1 is sealed with a packaging container, the ceramic plate 1 may be sealed together with a desiccant.

For the packaging container or the package, the matters described in JP6703635B can be referred to.

### <Use of Ceramic Plate 1>

The ceramic plate 1 is preferably used as a heat dissipation member for dissipating heat generated from an electronic component in an electric or electronic product.

The ceramic plate 1 can be connected to an electronic component with solder to form a module. In addition, an electric or electronic product can be manufactured using this module. Since the ceramic plate 1 can be appropriately connected to the electronic component by soldering, these modules and electric or electronic products have high reliability.

Although the embodiments of the present invention have been described above, these are examples of the present invention, and various configurations other than the above can be adopted. In addition, the present invention is not limited to the embodiments described above and modifications, improvements, and the like are included in the present invention in a range in which it is possible to achieve the object of the present invention.

### Examples

A detailed description will be given of embodiments of the present invention based on Examples and Comparative Examples. It should be noted that the present invention is not limited to Examples only.

### <Manufacturing of Ceramic Plate>

### (Formation of Porous Silicon Carbide Body)

300 g of silicon carbide powder A (manufactured by Pacific Rundum Co., Ltd.: NG-150, average particle size: 100 µm), 150 g of silicon carbide powder B (manufactured by Yakushima Denko Co., Ltd.: GC-1000F, average particle size: 10 µm), and 30 g of silica sol (manufactured by Nissan Chemical Operation: SNOWTEX) were mixed with each other using a stirring mixer for 30 minutes. The obtained mixture was put into a mold of 178 mm × 128 mm × 5.5 mm and was pressed at a pressure of 10 MPa. This was fired in the atmosphere at a temperature of 900°C for 2 hours. In this way, a porous silicon carbide body was obtained.

For the sake of completeness, thirty sheets of the same porous silicon carbide body were produced for the following steps.

Both surfaces of the porous silicon carbide body were interposed between stainless steel (SUS 304) sheets having a dimension of 210 mm × 160 mm × 0.8 mm and having both surfaces to which a release agent was applied, and 30 bodies were laminated. Then, iron plates having a thickness of 6 mm were disposed at both ends. Further, after that, the blocks were fixed with bolts and nuts having a diameter of 10 mmφ to form one block.

### (Formation of Aluminum-Silicon Carbide Composite)

The above-described block was preheated using an electric furnace at a temperature of 600°C. Next, this block was put into a press mold having a void with an internal dimension of 400 mmφ × 300 mm that was heated in advance.

Next, molten aluminum alloy having a temperature of 800°C and having a composition including 12% of silicon, 1% of magnesium, and a remainder consisting of aluminum and inevitable impurities was poured into the press mold and was pressurized at a pressure of 100 MPa for 20 minutes. As a result, the porous silicon carbide body was impregnated with the aluminum alloy to obtain a metal block including the aluminum-silicon carbide composite.

The obtained metal lump was cooled to room temperature. Thereafter, the metal lump was cut along the side surface shape of the release plate using a wet band saw. Then, the stainless steel plate that was interposed was peeled off.

In this way, an aluminum-silicon carbide composite was obtained.

### (Treatment after Impregnation)

The outer periphery of the obtained aluminum-silicon carbide composite was processed with an NC lathe to have a size of 180 mm × 130 mm in the vertical and horizontal directions. Thereafter, through holes with a diameter of 7 mm were processed at 8 locations around the outer edge portion and countersunk holes with a diameter of φ10-4 mm were processed at 4 locations.

After the above-described processing treatment, the composite body was subjected to a blast treatment with alumina abrasive grains under conditions of a pressure of 0.4 MPa and a transportation speed of 1.0 m/min for cleaning.

Further, after that, the complex was subjected to electroless Ni-P plating, and then Ni-B plating was further performed. As a result, a plating film having a thickness of 8 µm (Ni-P: 6 µm, Ni-B: 2 µm) was formed on the surface of the complex.

### (Heating step (Intended to Release Hydrogen))

The composite body on which the plating film was formed was placed in a furnace (manufactured by Yamato Scientific Co., Ltd., product number: DFS72) of a forced air circulation type and heated in the atmosphere at a temperature shown in Table 1 for 1 hour. Thereafter, the mixture was allowed to cool to room temperature.

### [Table 1]

**Table 1**

| Example /Comparative Example No. | Heating temperature in heating step (intended to release hydrogen) |
|---|---|
| Example 1 | 250°C |
| Comparative Example 1 | 180°C |

As described above, ceramic plates of Examples and Comparative Examples were obtained.

### <Measurement of Release Amount of Hydrogen by Temperature-Programmed Desorption Gas Analysis Method>

As the apparatus, a gas extraction and mass spectrometry apparatus in a vacuum: AGS-7000 model manufactured by Canon Anelva Co., Ltd., and a mass spectrometer: quadrupole mass spectrometer M201QA-TDM model manufactured by Canon Anelva Co., Ltd. were used, and the analysis was performed according to the following procedure.
(1) The ceramic plate was cut to obtain a sample having a mass shown in the table below. In this case, the way of cutting was taken into consideration so that (mass of plating layer in sample)/(mass of entire sample) was about the same as (mass of plating layer)/(mass of ceramic plate) in the ceramic plate before cutting the sample.
(2) The sample was stored in a desiccator until just before the following (3) was carried out.
(3) The sample was taken out from the desiccator and weighed. Then, the sample was continuously loaded into the device.
(4) After loading the sample into the device, the sample was exhausted for 2 hours. Thereafter, the measurement and the heating were started.
(5) The release amount of hydrogen gas in the measurement temperature range was measured in real time, and the plot was made with the vertical axis: the release amount of hydrogen per unit mass of the sample (the mass spectral intensity based on the ion current value) and the horizontal axis: the temperature T. As a result, a hydrogen gas release curve was obtained.

The measurement conditions were as follows.
Ionization energy: 70 eV
Applied voltage of secondary electron multiplier: -1150 V Measurement mass range (m/z) 1 to 200
Measurement temperature range: room temperature (25°C) to 400°C
Temperature rising rate: 300°C/hr (5°C/min)
Initial pressure at start of measurement: approximately 2 × 10⁻⁶ Pa

In addition, for the release amount of hydrogen, a hydrogen analysis control sample JSS GS-7a (hydrogen content: 6.0 ppm) sold by the Japan Iron and Steel Federation was heated from room temperature (25°C) to 1000°C at the same temperature rising rate (300°C/hr) as the measurement sample, and the measured raw data was calibrated with the obtained amount of hydrogen gas released as a reference.

From the obtained hydrogen gas release curve, the release amount A₂₅₀ of hydrogen per unit mass of the ceramic plate (sample) at 250°C and the small amount A₃₀₀ of hydrogen released per unit mass of the ceramic plate (sample) at 300°C were read. In addition, the integral value of the hydrogen gas release curve in a region from room temperature (25°C) to 400°C was determined to obtain the hydrogen cumulative release amount per unit mass of the ceramic plate (sample).

Table 2 summarizes the release amount of various kinds of hydrogen. The unit (A/g) of A₂₅₀ and A₃₀₀ represents a mass spectral intensity based on an ion current value.

### [Table 2]

**Table 2**

| Example /Comparative Example No. | A₂₅₀ (A/g) | A₃₀₀ (A/g) | A₂₅₀/A₃₀₀ | Hydrogen cumulative release amount |
|---|---|---|---|---|
| Example 1 | 4.0×10⁻¹¹ | 1.9×10⁻¹⁰ | 0.21 | 9.2×10⁻³ |
| Comparative Example 1 | 8.6×10⁻¹⁰ | 8.3×10⁻¹⁰ | 1.04 | 1.6×10⁻² |

### <Solder Void Evaluation>

The analysis was performed according to the following procedure.
(1) A preform solder (dimensions: 55 mm × 50 mm × 0.2 mm, composition: Sn63%, Pb37%) was placed on a ceramic plate.
(2) The mixture was subjected to reflow under the conditions of 250°C and 30 minutes, and then cooled.
(3) The mixture was reflowed again under the condition of 250°C for 30 minutes and then allowed to cool.
(4) After the completion of (2) and (3), the ceramic plate was subjected to X-ray imaging, and the presence or absence of voids and the degree of the voids in a case where voids were present were evaluated from the obtained transmission image. A case where there was no void or the void was at a practically acceptable level was evaluated as OK, and a case where the amount of void was at a practically unacceptable level was evaluated as NG.

The evaluation results are shown in Table 3.

### [Table 3]

**Table 3**

| Example /Comparative Example No. | After reflow | After reflow again |
|---|---|---|
| Example 1 | OK | OK |
| Comparative Example 1 | OK | NG |

As shown in the above table, by using the ceramic plate having a small amount of hydrogen released during heating as in Example 1, voids in the reflowed again solder could be reduced.

The void is known as one of the causes of the connection failure during soldering. Therefore, it can be said that the ceramic plate having a small amount of hydrogen released during heating can be used to appropriately connect the ceramic plate and the electronic component by soldering.

In addition, it is understood that, due to the difference in manufacturing conditions of the ceramic plates of Example 1 and Comparative Example 1, that is, the difference in heating temperature in the heating step (intended to release hydrogen), the ceramic plate after the formation of the plating film can be heated at a relatively high temperature, whereby it is possible to manufacture a ceramic plate having a small hydrogen release amount.

### <Additional Examples and Evaluation>

Ceramic plates were manufactured in the same manner as in Example 1 (Examples 2 to 4), except that in the above-described (Heating step (Intended to Release Hydrogen)), the heating temperature was changed to the temperature shown in Table 4 below. Then, the release amount of hydrogen was measured by a temperature-programmed desorption gas analysis method. This is summarized in Tables 4 and 5 below.

### [Table 4]

**Table 4**

| Example /Comparative Example No. | Heating temperature in heating step (intended to release hydrogen) |
|---|---|
| Example 2 | 200°C |
| Example 3 | 220°C |
| Example 4 | 230°C |

### [Table 5]

**Table 5**

| Example /Comparative Example No. | A₂₅₀ (A/g) | A₃₀₀ (A/g) | A₂₅₀/A₃₀₀ | Hydrogen cumulative release amount |
|---|---|---|---|---|
| Example 2 | 2.1×10⁻¹⁰ | 1.2×10⁻⁹ | 0.18 | 15.4×10⁻³ |
| Example 3 | 1.0×10⁻¹⁰ | 7.0×10⁻¹⁰ | 0.14 | 10.6×10⁻³ |
| Example 4 | 7.3×10⁻¹¹ | 5.5×10⁻¹⁰ | 0.13 | 9.9×10⁻³ |

Even in a case where the preform solder was placed on the ceramic plate of each of these additional examples and subjected to reflow and reflow again, the generation of voids was suppressed. That is, it can be said that even in a case where the ceramic plate of these additional examples is used, the ceramic plate and the electronic component can be appropriately connected to each other by soldering.

The present application claims priority based on Japanese Patent Application No. 2023-028700 filed on February 27, 2023, the entire content of which is incorporated herein by reference.

### REFERENCE SIGNS LIST

1 ceramic plate
3 plate-like ceramic member
5 plating film
7 hole
10 press convex mold
11 press concave mold

## Claims

1. A ceramic plate comprising:
a plating film on at least a part of a surface of a plate-like ceramic member,
wherein when the ceramic plate is heated from 25°C to 400°C at a temperature rising rate of 5 °C/min according to a temperature-programmed desorption gas analysis method, a release amount A₂₅₀ of hydrogen per unit mass of the ceramic plate at 250°C is 5.0 × 10⁻¹⁰ A/g or less in terms of a mass spectral intensity based on an ion current value.

2. The ceramic plate according to Claim 1,
wherein when a release amount of hydrogen per unit mass of the ceramic plate at 300°C in a measurement by the temperature-programmed desorption gas analysis method is defined as A₃₀₀, a value of A₂₅₀/A₃₀₀ is 0.3 or less.

3. The ceramic plate according to Claim 1 or 2,
wherein in a measurement by the temperature-programmed desorption gas analysis method, a release amount A₃₀₀ of hydrogen per unit mass of the ceramic plate at 300°C is 5.0 × 10⁻⁹ A/g or less in terms of a mass spectral intensity based on an ion current value.

4. The ceramic plate according to Claim 1 or 2,
wherein the plating film is an electroless plating film.

5. The ceramic plate according to Claim 1 or 2,
wherein the plating film contains at least any element selected from the group consisting of nickel and copper.

6. The ceramic plate according to Claim 1 or 2,
wherein a material of the plate-like ceramic member is a metal-silicon carbide composite.

7. A ceramic plate according to Claim 6,
wherein a metal in the metal-silicon carbide composite is at least any one selected from the group consisting of aluminum and magnesium.

8. The ceramic plate according to Claim 1 or 2,
wherein a hydrogen cumulative release amount per unit mass of the ceramic plate in a measurement by the temperature-programmed desorption gas analysis method is 2 × 10⁻² mL/g or less.

9. A package wherein the ceramic plate according to Claim 1 or 2 is sealed with a packaging container.

10. A manufacturing method for the ceramic plate according to Claim 1 or 2, the method comprising:
a heating step of heating a material that includes the plating film on at least a part of the surface of the plate-like ceramic member at 190°C or higher.

11. A manufacturing method for the ceramic plate according to Claim 10,
wherein in the heating step, the heating is performed for 30 minutes or more.

12. A module wherein the ceramic plate according to Claim 1 or 2 and an electronic component are connected to each other by solder.

13. An electric or electronic product comprising the module according to Claim 12.
